# EUROPÄISCHE PATENTSCHRIFT

(11) **EP 1 939 953 B1**
(45) Veröffentlichungstag und Bekanntmachung des Hinweises auf die Patenterteilung: **07.02.2018**
(21) Anmeldenummer: 07122425.7
(22) Anmeldetag: 05.12.2007
(51) Int. Cl.: H01L 51/52

(54) **Lichtemittierende Vorrichtung**
Light emitting device
Dispositif émettant de la lumière

(30) Priorität: 29.12.2006 DE 102006061943
(43) Veröffentlichungstag der Anmeldung: 02.07.2008
(73) Patentinhaber: OSRAM OLED GmbH, 93049 Regensburg (DE)
(72) Erfinder: Frischknecht, Kyle D., 93117 Goleta, CA (US)
(74) Vertreter: Epping - Hermann - Fischer

(56) Entgegenhaltungen:
- WO-A1-2006/101378
- JP-A- 2004 227 792
- JP-A- 2005 166 315
- US-A1- 2002 149 035
- US-A1- 2004 027 066
- US-A1- 2006 093 795
- US-A1- 2006 273 304

## Beschreibung

Die Erfindung betrifft eine lichtemittierende Vorrichtung insbesondere eine flächig ausgebildete, wie sie z. B. als Beleuchtungselement oder als Display eingesetzt werden kann. Flächig ausgebildete lichtemittierende Elemente können insbesondere in Form elektrolumineszierender Schichten, als Leuchtdioden oder als organische Leuchtdioden (OLED) realisiert sein. Derartige lichtemittierende Elemente sind üblicherweise auf einem Substrat aufgebracht und mit einer Abdeckung verkapselt.

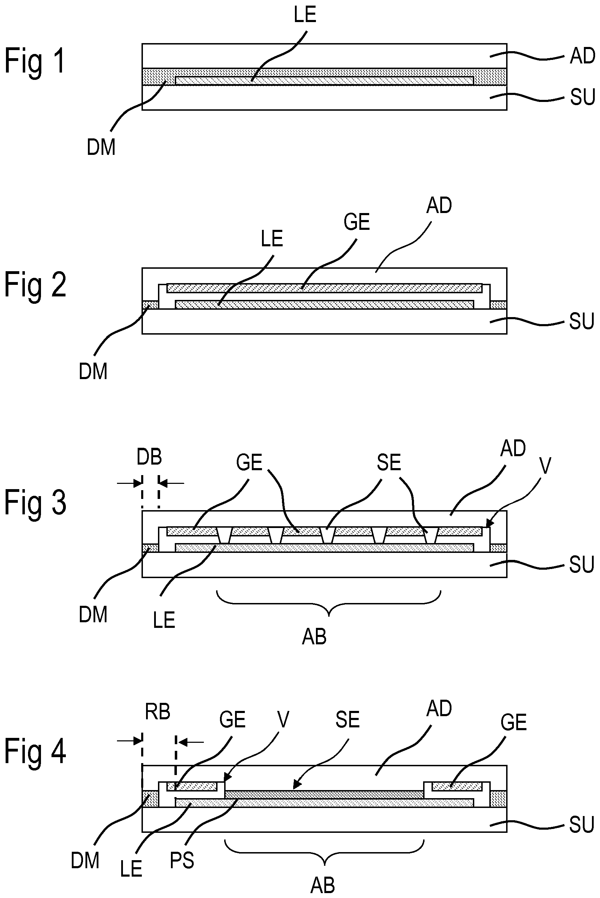

Figur 1 zeigt eine bekannte Verkapselung, wie sie insbesondere für OLEDs eingesetzt wird. Das Bauelement umfasst ein Substrat SU, auf dem ein lichtemittierendes Element LE, beispielsweise eine flächige OLED angeordnet ist. Auf diese Anordnung ist mit Hilfe einer vorzugsweise elastischen Dicht- und Klebemasse DM eine flächige, feste Abdeckung AD aufgeklebt. Ein lichtemittierendes Element mit einer solchen Verkapselung hat den Vorteil, dass die Größe von lichtemittierendem Element und Abdeckung beliebig skalierbar sind. Die Verkapselung ist außerdem nicht kompressibel und somit im Wesentlichen druckunempfindlich. Schwachpunkt an dieser Verkapselung sind jedoch die bis zur OLED führenden Grenzflächen zwischen den Abdeckschichten, entlang deren sich Diffusionspfade für Sauerstoff und/oder Feuchtigkeit ausbilden, die eine dagegen empfindliche OLED angreifen können. Dabei werden entweder deren metallische Elektroden oder deren organische Funktionsschicht angegriffen. Darüber hinaus weisen insbesondere größere Elemente, beispielsweise mit einem diagonalem Durchmesser von mehr als fünf Zentimetern, bei gleichzeitig dünner werdenden Materialschichtdicken von beispielsweise bis nur 0,7 Millimeter eine gewisse Flexibilität auf, die einen ausreichend festen und dichten Verbund der unterschiedlichen Materialschichten gefährden und zu Korrosion oder Beschädigung führen können. Weitere schädliche Einwirkungen können bei Temperaturwechsel oder bei wechselndem Umgebungsdruck erfolgen, wie er beispielsweise beim Transport mittels Luftfracht auftreten kann. In der Folge kann eine Delaminierung des Klebe- und Dichtmittels DM oder sogar ein Bruch des üblicherweise aus Glas bestehenden Substrats auftreten.
Figur 2 zeigt eine weitere bekannte Verkapselung, wie sie insbesondere für OLEDs eingesetzt werden kann. Diese umfasst im Gegensatz zur Figur 1 eine Abdeckung AD, die über dem lichtemittierenden Element LE eine Ausnehmung aufweist und dieses somit berührungsfrei abdecken kann. Umlaufend sitzt die Abdeckung auf dem Substrat SU auf und ist gegen dieses mit einem Dichtmittel DM abgedichtet. Des Weiteren kann auf der Innenseite der Abdeckung im Abstand vom lichtemittierenden Element ein Getter-Material GE angeordnet sein, welches zur Absorption beziehungsweise zum Binden von Sauerstoff und/oder Feuchtigkeit geeignet ist. Dieses verhindert, dass im Fall des Eindringens für die OLED schädlicher Stoffe dennoch keine Beschädigungen der OLED auftreten. In dieser Ausführung sind auch die Kanten der Verkapselung besser geschützt, weil kein durchgehender Diffusionspfad an der Grenzfläche zwischen benachbarten Schichten hin zur OLED führt. Dies ermöglicht eine höhere Lebensdauer des verkapselten lichtemittierenden Elements. Nachteilig an dieser Verpackung ist jedoch, dass die freitragende Abdeckung mit zunehmender Fläche empfindlich gegen eine Kompression und damit gegen mechanischen oder Umgebungsdruck wird, was einen direkten Kontakt des Getter-Materials mit der OLED oder die bereits anhand der Verpackung gemäß Figur 1 angeführten Schäden zur Folge haben kann. Eine Verkapselung gemäß Figur 2 ist daher nicht für großflächige lichtemittierende Elemente geeignet.

Die Druckschrift US 2004/0027066 beschreibt ein organisches elektrolumineszierendes Bauelement, bei dem auf einem unteren Substrat Bereiche mit einer organischen Licht emittierende Schicht ausgebildet sind, über denen ein oberes Substrat ausgebildet ist, das mittels einer Klebeschicht auf dem unteren Substrat befestigt ist. Zwischen den Substraten sowie zwischen den Bereichen mit der organischen Licht emittierenden Schicht ist eine Abstand haltende Struktur angeordnet.

Die Druckschrift JP 2005-166315 beschreibt ein organisches elektrolumineszierendes Bauelement mit einem Aktiv-Matrix-Substrat, das zwischen strukturierten Elektroden organische Schichten aufweist. Darüber ist ein Verkapselungssubstrat angeordnet, wobei Abstandshalter zwischen den Substraten auf der oberen Elektrode über Bereichen angeordnet sind, die frei von der unteren Elektrode sind.

Die Druckschrift US 2006/0273304 beschreibt ein gebogenes OLED-Bauelement mit einem Substrat, auf dem zwischen Elektroden organische Schichten angeordnet sind. Darüber ist eine Abdeckung aufgeklebt. Das Substrat oder die Abdeckung kann eine Mehrzahl erhabener Bereiche als Abstandshalter aufweisen, mittels derer das Bauelement vor einer Deformation unter äußerer Druckeinwirkung geschützt werden kann.

Die Druckschrift US 2002/0149035 beschreibt ein elektrolumineszierendes Bauelement mit einem Substrat, auf dem eine Mehrzahl erster Elektroden, eine organische oder anorganische Emissionsschicht und eine zweite Elektrode ausgebildet sind. Darüber ist ein Abdeckelement angeordnet, wobei zwischen der zweiten Elektrode und dem Abdeckelement eine Vielzahl von Schockabsorberelementen aus einem flexiblen Material angeordnet ist.
Die Druckschrift JP 2004-227792 beschreibt ein organisches elektrolumineszierendes Bauelement mit einem Substrat und einer Verkapselungsschicht, zwischen denen auf dem Substrat organische Schichten in Form von durch Trennstrukturen voneinander getrennten Pixeln ausgebildet sind. Über den Trennstrukturen sind Erhebungen auf der Verkapselungsschicht als Abstandshalter ausgebildet. Das Dokument US2005/0046344A beschreibt eine licht-emittierende Vorrichtung. Die Druckschrift WO 2006/101378 beschreibt ein organisches Licht emittierendes Bauelement mit einem Substrat, auf dem eine erste Elektrode, eine Emissionsschicht und eine zweite Elektrode in Form einer Emissionseinheit angeordnet sind. Eine Abdeckung ist mittels eines Klebstoffs auf das Substrat aufgeklebt. Eine Mehrzahl von Abstandshaltern ist auf der Innenoberfläche 633 der Abdeckung ausgebildet.
Aufgabe der vorliegenden Erfindung ist es, eine lichtemittierende Vorrichtung anzugeben, die in der Fläche beliebig skalierbar ist, ohne dass dabei gleichzeitig die Gefahr einer Undichtigkeit oder einer Beschädigung der Vorrichtung in Kauf genommen werden muss.

Diese Aufgabe wird erfindungsgemäß durch eine lichtemittierende Vorrichtung mit den Merkmalen von Anspruch 1 gelöst. Vorteilhafte Ausgestaltungen der Erfindung sind weiteren Ansprüchen zu entnehmen.

Es wird eine lichtemittierende Vorrichtung vorgeschlagen, die die Vorteile der beiden vorgestellten bekannten Verkapselung verbindet, deren Nachteile aber vermeidet. Die Vorrichtung umfasst ein Substrat, auf dem ein lichtemittierendes Element flächig angeordnet ist. Darüber ist eine Abdeckung so angeordnet, dass das lichtemittierende Element zwischen Substrat und Abdeckung dicht eingeschlossen ist. Auf der Innenseite der Abdeckung ist eine sich zum lichtemittierenden Element öffnende Vertiefung vorgesehen, die zusammen mit dem lichtemittierenden Element einen Hohlraum einschließt. Im Hohlraum ist auf der Abdeckung ein Getter-Material angeordnet. Zusätzlich weist die Abdeckung zumindest ein Stützelement auf, mit dem sie sich in einem zentralen vom Rand des lichtemittierenden Elements entfernten Bereich auf diesem abstützt.
Mithin wird eine Vorrichtung angegeben, bei der mit Hilfe von in einer Abdeckung vorhandenen Vertiefungen Hohlräume über dem lichtemittierenden Element geschaffen werden, wobei durch das zumindest eine sich zentral über dem lichtemittierenden Element abstützendes Stützelement die Nachteile vermieden werden, die ansonsten mit einer über eine große Fläche freitragenden Abdeckung wie in Figur 2 verbunden sind. Das zumindest eine Stützelement verkleinert die Flächen, die mit der Abdeckung freitragend überbrückt werden müssen. Die dennoch geschaffenen Hohlräume über dem lichtemittierenden Element beinhalten das Getter-Material, das bei dennoch eindringender Feuchtigkeit und/oder eindringendem Sauerstoff eine Beschädigung des lichtemittierenden Elements verhindert oder zumindest über einen längeren Zeitraum verzögert.
Die vorgeschlagene Vorrichtung ist frei in ihrer Größe skalierbar, da durch das Stützelement größer werdende freitragende Abschnitte der Abdeckung vermieden werden können.
Bei einer bevorzugten Ausführungsform ist das lichtemittierende Element ein organisches strahlungsemittierendes Element, insbesondere eine organische Leuchtdiode (OLED), die gegenüber Feuchtigkeit und Sauerstoff besonders empfindlich ist. Eine OLED kann dabei eine organische Schicht oder eine Schichtenfolge mit zumindest einer organischen Schicht aufweisen mit einem aktiven Bereich, der im Betrieb elektromagnetische Strahlung aussenden kann. Weiterhin kann eine OLED eine erste Elektrode und eine zweite Elektrode aufweisen, wobei die organische Schicht oder die Schichtenfolge mit zumindest einer organischen Schicht mit dem aktiven Bereich zwischen der ersten und zweiten Elektrode angeordnet sein kann. Die erste und die zweite Elektrode können dabei geeignet sein, "Löcher" beziehungsweise Elektronen in den aktiven Bereich zu injizieren, die dort unter Emission von elektromagnetischer Strahlung rekombinieren können.

Weiterhin kann die erste Elektrode auf dem Substrat angeordnet sein. Über der ersten Elektrode kann die organische Schicht oder die Schichtenfolge mit einer oder mehreren funktionalen Schichten aus organischen Materialien aufgebracht sein. Die funktionalen Schichten, die den aktiven Bereich umfassen können, können dabei beispielsweise Elektronentransportschichten, elektrolumineszierende Schichten und/oder Lochtransportschichten umfassen. Über den funktionalen Schichten beziehungsweise über der zumindest einen organischen Schicht kann die zweite Elektrode aufgebracht sein.

Abdeckung und Substrat sind mit einem Dichtmittel verbunden, welches nahe der Kante der Abdeckung in einem umlaufenden Dichtbereich angeordnet ist und die äußere Fuge zwischen Abdeckung und Substrat abdichtet. Die Fläche des lichtemittierenden Elements wird dabei vorzugsweise geringer als die der Abdeckung gewählt, so dass das lichtemittierende Element innerhalb einer vom Dichtbereich umschlossenen Fläche angeordnet ist.

Beispielsweise kann das Substrat Glas, Quarz, Kunststofffolien, Metall, Metallfolien, Siliciumwafer oder ein beliebiges anderes geeignetes Substratmaterial umfassen. Das Substrat kann auch als Schichtenfolge oder Laminat mehrerer Schichten ausgeführt sein. Ist das organische strahlungsemittierende Bauelement als so genannter "Bottom-Emitter" ausgeführt, das heißt, dass die im aktiven Bereich erzeugte elektromagnetische Strahlung durch das Substrat abgestrahlt wird, so weist das Substrat vorteilhafterweise eine Transparenz für zumindest einen Teil der elektromagnetischen Strahlung auf.

In der Bottom-Emitter-Konfiguration kann vorteilhafterweise die erste auf dem Substrat aufliegende Elektrode transparent für zumindest einen Teil der elektromagnetischen Strahlung sein. Eine transparente erste Elektrode, die als Anode ausgeführt sein kann und somit als positive Ladungen oder "Löcher" injizierendes Material dienen kann, kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären MetallSauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin müssen die TCOs nicht zwingend einer stöchiometrischen Zusammensetzung entsprechen und können auch p- oder n-dotiert sein. Alternativ oder zusätzlich kann die erste Elektrode auch ein Metall, beispielsweise Silber, aufweisen.

Die Schichtenfolge mit zumindest einer organischen Schicht kann Polymere, Oligomere, Monomere, organische kleine Moleküle ("organic small molecules") oder andere organische nichtpolymere Verbindungen oder Kombinationen daraus aufweisen. Insbesondere kann es vorteilhaft sein, wenn eine funktionale Schicht der Schichtenfolge als Lochtransportschicht ausgeführt ist um eine effektive Löcherinjektion in eine elektrolumineszierende Schicht oder einen elektrolumineszierenden Bereich zu ermöglichen. Solche den aktiven Bereich oder die weiteren funktionalen Schichten und Bereiche betreffende Strukturen sind dem Fachmann insbesondere hinsichtlich Materialien, Aufbau, Funktion und Struktur bekannt und werden daher an dieser Stelle nicht näher erläutert.

Die zweite Elektrode kann als Kathode ausgeführt sein und somit als Elektronen injizierendes Material dienen. Als Kathodenmaterial können sich unter anderem insbesondere Aluminium, Barium, Indium, Silber, Gold, Magnesium, Calcium oder Lithium sowie Verbindungen, Kombinationen und Legierungen davon als vorteilhaft erweisen. Zusätzlich oder alternativ kann die zweite Elektrode auch transparent ausgeführt sein. Das bedeutet insbesondere, dass die OLED auch als "Top-Emitter" ausgeführt sein kann, das heißt, dass die im aktiven Bereich erzeugte elektromagnetische Strahlung auf der dem Substrat abgewandten Seite des organischen strahlungsemittierenden Bauelements abgestrahlt werden kann.

Soll eine Elektrode, die eine metallische Schicht aufweist oder aus einer solchen besteht, durchlässig für das von dem organischen Schichtstapel ausgesandte Licht ausgebildet sein, so kann es vorteilhaft sein, wenn die metallische Schicht hinreichend dünn ausgebildet ist. Bevorzugt liegt die Dicke einer solchen semitransparenten metallischen Schicht zwischen 1 nm und 100 nm, wobei die Grenzen eingeschlossen sind.

Weiterhin kann die erste Elektrode als Kathode und die zweite Elektrode als Anode ausgeführt sein, wobei das organische strahlungsemittierende Bauelement dabei als Bottom- oder Top-Emitter ausgeführt sein kann. Auch kann das organische strahlungsemittierende Bauelement gleichzeitig als Top-Emitter und als Bottom-Emitter ausgebildet sein.
Vorteilhaft umfassen Substrat und/oder Abdeckung eine Glasschicht. Glas hat den Vorteil, dass es transparent für emittierte Strahlung, kostengünstig, leicht verarbeitbar, diffusionsdicht und ausreichend mechanisch stabil ist. Zumindest eines aus Substrat und Abdeckung kann gegebenenfalls zusätzlich weitere Schichten umfassen und beispielsweise als Mehrschichtlaminat ausgebildet sein. Zumindest eines aus Substrat und Abdeckung ist für das vom lichtemittierenden Element abgestrahlte Licht zumindest teilweise durchlässig.
Der Hohlraum mit dem Getter-Material schließt sich vorteilhaft direkt an den Dichtbereich an, und erstreckt sich wie dieser vorteilhaft umlaufend und damit der Kante der Abdeckung folgend. Dies hat den Vorteil, dass das Getter-Material in der Nähe der potenziellen Eindringpfade für Sauerstoff und/oder Feuchtigkeit angeordnet ist.
Dabei ist es möglich, die Außenkante des lichtemittierenden Elements ausreichend entfernt vom Dichtbereich anzuordnen. Der Hohlraum kann sich dann zumindest über den durch diesen Abstand definierten Bereich erstrecken, wobei dann auch das Getter-Material zumindest in diesem Abstandsbereich angeordnet ist. Damit ist das Getter-Material dem Eindringpfad korrodierender Stoffe folgend vor dem lichtemittierenden Element angeordnet und kann diese Stoffe absorbieren und unschädlich machen, bevor sie das lichtemittierende Element erreicht haben.

Als Getter-Material werden vorzugsweise ein oxidierbares Material, welches mit Sauerstoff und Feuchtigkeit reagieren und diese Schadstoffe dabei binden kann, oder Zeolithe eingesetzt. Als leicht oxidierende Materialien werden insbesondere Metalle aus der Gruppe der Alkali- und Erdalkalimetalle eingesetzt. Jedoch sind auch andere Metalle wie beispielsweise Titan oder oxidierbare nichtmetallische Materialien geeignet. Geeignete Getter-Materialien sind im Stand der Technik in ausreichender Anzahl bekannt und brauchen daher nicht einzeln aufgeführt werden.

Die Vorrichtung ist mit einem einzelnen Stützelement realisiert welches zentral auf einem Abstützbereich aufliegt, der den flächenmäßig überwiegenden Anteil des lichtemittierenden Elements umfasst. Im Abstützbereich ist zwischen Stützelement und lichtemittierenden Element eine Pufferschicht angeordnet, die ein organisches und/oder anorganisches Material umfassen kann. Der Abstützbereich umfasst die gesamte Fläche des lichtemittierenden Elements so dass dieses vollständig von der Pufferschicht und dem darauf aufliegenden Stützelement abgedeckt ist. Diese Variante hat den Vorteil, dass das lichtemittierende Element in der Vorrichtung gleichmäßig mechanisch belastet ist, so dass die Gefahr lokaler Funktionsveränderungen durch unterschiedliche Belastung oder die nur lokal aufliegende Abdeckung vermieden wird.

Das zentrale Stützelement und die dieses ringförmig umschließende Vertiefung können separat gebildet sein. Vorteilhaft ist jedoch eine Abdeckung, bei der das einzelne zentrale Stützelement durch eine beispielsweise ringförmig geschlossene Vertiefung definiert beziehungsweise strukturiert ist. Möglich ist es auch, im Bereich des zentralen Stützelements weitere Ausnehmungen beziehungsweise Vertiefungen in der Abdeckung vorzusehen, und in diesen ebenfalls Getter-Material anzuordnen.

Die im Dichtbereich angeordnete Dichtmasse und die Pufferschicht zwischen Stützelement und lichtemittierenden Element können aus dem gleichen Material bestehen. Geeignet dazu sind insbesondere Reaktionsharze, die das Herstellen einer Klebe- und Dichtverbindung erleichtern. Die Reaktionsharze können als ein- oder mehrkomponentige Harze realisiert sein die thermisch oder mit Hilfe von Licht oder durch kombinierte Härtung auszuhärten sind. Geeignete Materialien finden sich beispielsweise in der Klasse der Epoxide, die sowohl als Dicht- als auch als Klebemittel geeignet sind.

Möglich ist es jedoch auch, Dichtmasse und Pufferschicht aus unterschiedlichen Materialien auszubilden, wobei die Materialien entsprechend dem gewünschten Einsatzzweck ausgewählt sein können. Während für die Dichtmasse ein Material mit guter Adhäsion, hoher Feuchtigkeitsdichte und guten mechanischen Formstoffeigenschaften vorteilhaft ist, sind diese Eigenschaften für die Pufferschichten ohne Belang. Für die Pufferschicht ist ein weiches und vorzugsweise elastisches Material bevorzugt, welches keine Klebeeigenschaften aufweisen muss.

Vorzugsweise umfasst die Abdeckung zum Substrat weisend zumindest eine Glasschicht, in die zumindest eine Vertiefung eingeprägt ist. Die Vertiefung kann dabei einseitig eingeprägt sein, so dass die gegenüberliegende Oberfläche der Glasschicht plan ist. Möglich ist es jedoch auch, die Vertiefungen durchzuprägen, was auf der der Vertiefung gegenüberliegenden Seite der Glasschicht eine entsprechende Auswölbung zur Folge hat. Das Prägen erfolgt z.B. während der Herstellung der Abdeckung während die Glasschicht erweicht ist. Möglich ist es jedoch auch, die gewünschten Vertiefungen in die Glasschicht einzuätzen. Das Ätzen hat den Vorteil, dass die Abdeckung mit hoher Strukturgenauigkeit strukturiert werden kann, was insbesondere für die genaue Lage und die Abmessungen des oder der Stützelemente von Bedeutung ist. Vorteilhaft ist es auf jeden Fall, wenn das zumindest eine Stützelement aus dem Material der Abdeckung besteht und integraler Bestandteil derselben ist.

Das Stützelement kann jedoch auch mit der Abdeckung durch Aufkleben, Aufschmelzen oder Aufschweißen verbunden sein. Das Stützelement wird dann als separater Körper hergestellt und mit der Abdeckung verbunden.

Die Strukturierung des lichtempfindlichen Elements erfolgt beispielsweise so, dass Teilbereiche entstehen, die unabhängig von einander elektrisch angesteuert werden können. Die Teilbereiche können beliebig kleine Flächen sein, wobei jedoch bevorzugt eine minimale Strukturgröße der Teilbereiche bei gleichzeitig maximaler Anzahl unabhängiger Teilbereiche angestrebt wird, um mit den unabhängig ansteuerbaren Teilbereichen des lichtemittierenden Elements im Fall einer Bildwiedergabe eine entsprechend hohe Auflösung zu erzielen. In einer weiteren Ausgestaltung weist die Abdeckung im Dichtbereich auf der zum Substrat hin weisenden Oberfläche eine wulstartige, umlaufende Erhebung auf, die zumindest über die Vertiefungen erhaben ist. Die Oberfläche des Wulstes entspricht dann dem Dichtbereich und ist vorzugsweise planparallel ausgeführt, um eine optimale Abdichtung zum Substrat zu erzielen. Der Höhenunterschied der Wulstoberfläche relativ zu der Abstützfläche des Stützelements wird auf einen Wert eingestellt, der maximal der Erhebung des lichtemittierenden Elements über der Oberfläche des Substrats entspricht. Bei geeigneter Wahl dieser Größenverhältnisse wird erreicht, dass im Dichtbereich eine minimale Schichtdicke an Dichtmasse erforderlich ist, was zu einer höheren Dichtigkeit und damit zu einem geringeren möglichen Eindringen von korrodierenden Stoffen wie Feuchtigkeit und/oder Sauerstoff führt.
Im Folgenden wird die Erfindung anhand von Ausführungsbeispielen und der dazugehörigen Figuren näher erläutert. Die Figuren dienen allein der Veranschaulichung der Erfindung und sind nur schematisch und nicht maßstabsgetreu ausgeführt.
Figur 1 zeigt eine bekannte Verkapselung für ein lichtemittierendes Element im schematischen Querschnitt,
Figur 2 zeigt ein weiteres bekanntes lichtemittierendes Element im schematischen Querschnitt,
Figur 3 zeigt ein erstes Beispiel einer erfindungsgemäßen lichtemittierenden Vorrichtung mit verteilten Stützelementen,
Figur 4 zeigt ein weiteres Beispiel mit einem zentralen großflächigen Stützelement,
Figur 5 zeigt ein Beispiel mit einer geprägten Abdeckung,
Figur 6 zeigt eine Ausführung mit einer im Dichtbereich aufgedeckten Abdeckung,
Figur 7 zeigt ein Element in der Draufsicht.

Figur 1 zeigt wie bereits erwähnt eine bekannte Vorrichtung mit einem lichtemittierenden Element LE, welches auf einem Substrat SU befestigt ist. Mit Hilfe eines Dichtmittels DM ist eine Abdeckung AD über dem lichtemittierenden Element angeordnet.
Figur 2 zeigt eine weitere bekannte Vorrichtung, bei der die Abdeckung AD kappenartig ausgebildet ist und das lichtemittierende Element LE berührungsfrei abdeckt. Das Dichtmittel DM ist hier auf den Auflagebereich der Abdeckung, der dem Dichtbereich entspricht, beschränkt. Auf der Innenseite der Abdeckung AD ist ein Getter-Material GE aufgebracht.
Figur 3 zeigt die vorgeschlagene, demgegenüber verbesserte Vorrichtung, bei der die Abdeckung AD mit Hilfe von Stützelementen SE, die integraler Bestandteil der Abdeckung sind, auf dem lichtemittierenden Element LE aufsitzt. Die Stützelemente SE sind zum Beispiel gleichmäßig auf einem Abstützbereich AB aufgestützt. Auf der Innenseite der Abdeckung AD ist zwischen den beliebig geformten, hier mit konischem Querschnitt dargestellten Stützelementen Getter-Material GE aufgebracht. In diesem Beispiel ist die Abdeckung AD mit einer einzigen, nur von den Stützelementen SE unterbrochenen Vertiefung V versehen. Im äußeren, dem Dichtbereich DB entsprechenden Bereich der Abdeckung AD ist die Unterkante der Abdeckung z.B. in einer Ebene mit der Unterkante der Stützelemente SE, kann aber davon abweichen, je nach dem wie die Schichtdicke des Dichtmittels zwischen Abdeckung AD und Substrat SU gewählt werden soll.

Figur 4 zeigt ein weiteres Beispiel einer Vorrichtung, bei der sich die Abdeckung AD zentral in einem Abstützbereich AB auf dem lichtemittierenden Element LE abstützt. Der Abstützbereich AB umfasst den flächenmäßig größeren Anteil des lichtemittierenden Elements LE. Beiderseits des Stützelements SE ist in der Abdeckung eine Vertiefung V vorgesehen, die vorzugsweise das zentrale Stützelement SE ringförmig umschließt. In der Vertiefung ist ein Getter-Material GE so angeordnet, dass es nicht in Kontakt mit dem lichtemittierenden Element insbesondere der OLED tritt.
Das Substrat SU weist einen das lichtemittierende Element LE umschließenden Randbereich RB auf. Innerhalb dieses Randbereichs, jedoch im Abstand zur Außenkante des lichtemittierenden Elements LE ist der Dichtbereich DB vorgesehen, in dem ein Dichtmittel DM zwischen Abdeckung AD und Substrat SU vorgesehen ist und die Fuge zwischen den beiden die Verkapselung bildenden Elementen abdichtet. Zwischen zentralem Stützelement SE und lichtemittierendem Element LE ist eine Pufferschicht PS angeordnet, die sowohl mit Stützelement SE als auch mit lichtemittierendem Element LE in Kontakt tritt.
Die Vertiefung V ist in der Nähe des Dichtbereichs vorgesehen oder schließt an diesen an und kann vollständig innerhalb des Randbereichs RB angeordnet sein. Möglich ist es jedoch auch, wie in der Figur 4 dargestellt, dass das lichtemittierende Element LE in die Vertiefung V hineinragt. Die dem lichtemittierenden Element LE abgewandte Oberfläche der Abdeckung AD kann plan sein.

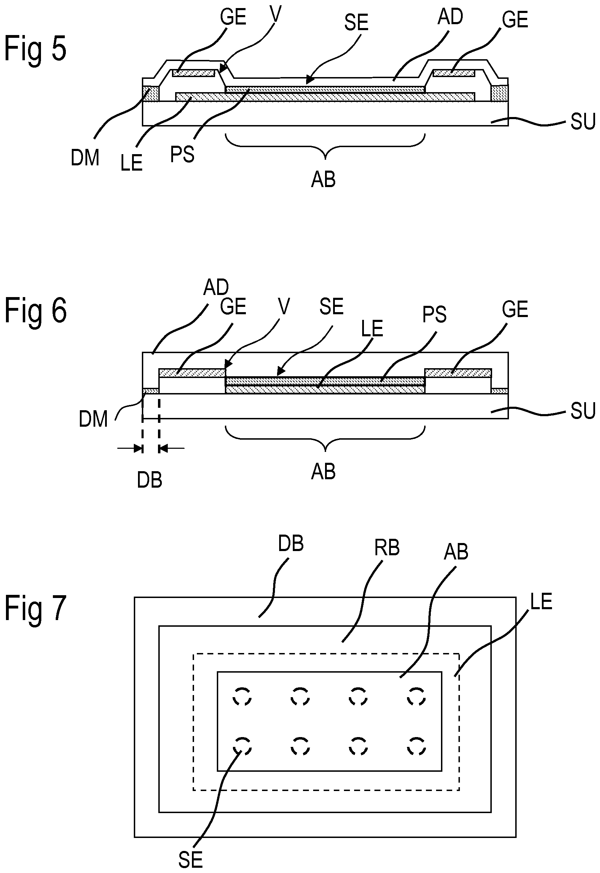

Figur 5 zeigt ein Beispiel, bei der die Abdeckung AD zumindest eine Glasschicht umfasst, in die die Vertiefungen V eingeprägt sind. Dies kann im flüssigen beziehungsweise erweichten Zustand der Glasschicht erfolgen, welche beispielsweise eine dünne Glasfolie ist. Das Einprägen der Vertiefungen V kann auch durch Gießen einer Glasfolie in eine entsprechend ausgestaltete Glasform erfolgen.
Die Abdeckung beziehungsweise die Glasschicht der Abdeckung kann dabei eine gleichmäßige Schichtdicke aufweisen. Möglich ist es jedoch auch, das Foliengießen so durchzuführen, dass die vom lichtemittierenden Element LE wegweisende Oberfläche plan ist. Alternativ ist es möglich, die Vertiefungen V in der Glasschicht durch nachträgliches Strukturieren herzustellen, beispielsweise durch Ätzen oder Embossing (Prägen). Im Beispiel nach Figur 3 mit einer Vielzahl über den Abstützbereich AB verteilter Stützelemente kann die Strukturierung der Vertiefung V gleichzeitig mit der Strukturierung der Stützelemente SE verbunden werden. Möglich ist es jedoch auch, die Stützelemente nachträglich in der Vertiefung vorzusehen.
Figur 6 zeigt eine Ausführung mit zwei weiteren Details, die unabhängig davon mit den Beispiele gemäß der übrigen Figuren kombiniert werden können. In diesem Fall weist das Stützelement eine Auflagefläche auf, die den gesamten Abstützbereich einnimmt und ungefähr der Grundfläche des lichtemittierenden Elements LE entspricht, so dass dieses vollständig von Pufferschicht und Stützelement abgedeckt wird.
Figur 7 zeigt in der Draufsicht eine mögliche Aufteilung der Grundflächen einer lichtemittierenden Vorrichtung. Die Flächen beziehungsweise Begrenzungen sind dabei konzentrisch angeordnet, wobei die allgemeine Grundform der lichtemittierenden Vorrichtung eine beliebige Umrisslinie aufweisen kann, vorzugsweise jedoch rechteckig oder rund ist. Von außen nach innen gesehen schließt sich an die Außenkante der Abdeckung AD der Dichtbereich DB an. Direkt anschließend an den Dichtbereich DB ist der Randbereich RB vorgesehen, welcher frei von lichtemittierenden Element ist. Weiter innen und im Abstand vom Dichtbereich DB angeordnet ist der abstützende Bereich AB, innerhalb dessen entweder ein zentrales Stützelement SE auf dem lichtemittierenden Element LE aufliegt oder innerhalb dessen einzelne über den abstützenden Bereich AB verteilte kleinere Stützelemente SE verteilt sind. Die Vertiefung kann sich innen an den Dichtbereich DB anschließen und überlappt zumindest teilweise den Randbereich RB. Die gestrichelt eingezeichnete Außenkante des lichtemittierenden Elements LE schließt an den Randbereich an, kann aber auch mit dem Abstützbereich AB bzw. dessen äußerer Begrenzung zusammenfallen.

## Patentansprüche

1. Lichtemittierende Vorrichtung,
- mit einem Substrat (SU)
- mit einem flächig darauf angeordneten lichtemittierenden Element (LE)
- mit einer Abdeckung (AD),
- bei der das lichtemittierende Element zwischen Substrat und Abdeckung dicht eingeschlossen ist,
- bei der in der Abdeckung zumindest eine Vertiefung (V) vorgesehen ist, die zum lichtemittierenden Element hin geöffnet ist und mit diesem zusammen einen Hohlraum einschließt,
- bei der auf der Abdeckung im Hohlraum eingeschlossen ein Gettermaterial (GE) angeordnet ist,
- bei der die Abdeckung ein Stützelement (SE) aufweist, mit dem sie sich in einem zentralen vom Rand entfernten Abstützbereich (AB) auf dem lichtemittierenden Element abstützt,
- bei der das Stützelement (SE) zentral auf einem Abstützbereich (AB) aufliegt und eine Auflagefläche aufweist, die den gesamten Abstützbereich einnimmt, wobei im Abstützbereich zwischen Stützelement und lichtemittierendem Element eine organische, anorganische oder gemischte Pufferschicht (PS) angeordnet ist **dadurch gekennzeichnet dass** das Stützelement und die Pufferschicht das Licht emittierende Element vollständig abdecken.

2. Vorrichtung nach Anspruch 1,
bei der das lichtemittierende Element (LE) eine OLED ist.

3. Vorrichtung nach Anspruch 1 oder 2,
bei der zwischen Abdeckung (AD) und Substrat (SU) im Bereich der Außenkante der Abdeckung ein Dichtbereich (DB) vorgesehen ist, der frei von dem lichtemittierenden Element (LE) ist,
bei der zumindest im Dichtbereich umlaufend eine Dichtungsmasse (DM) angeordnet ist, die die äußere Fuge zwischen Abdeckung und Substrat abdichtet.

4. Vorrichtung nach Anspruch 3,
bei der sich der Hohlraum direkt an den Dichtbereich (DB) anschließt.

5. Vorrichtung nach Anspruch 3 oder 4,
bei der die Dichtmasse(DM) und die Pufferschicht (PS) aus dem gleichen Material bestehen.

6. Vorrichtung nach einem der Ansprüche 1 bis 4,
bei der Substrat (SU) und Abdeckung (AD) je eine Glasschicht umfassen.

7. Vorrichtung nach einem der Ansprüche 1 bis 6,
bei der das Gettermaterial (GE) ein oxidierbares Material ist, das mit Sauerstoff und Feuchtigkeit reagiert und diese dabei binden kann.

8. Vorrichtung nach einem der Ansprüche 1 bis 7,
bei der das Substrat (SU) für das vom lichtemittierenden Element (LE) abgestrahlte Licht zumindest teilweise durchlässig ist.

9. Vorrichtung nach einem der Ansprüche 1 bis 8,
bei der die Abdeckung (AD) eine Glasschicht umfasst, in die die zumindest eine Vertiefung (V) eingeprägt ist.

10. Vorrichtung nach einem der Ansprüche 1 bis 8,
bei dem das Stützelement (SE) aus dem Material der Abdeckung (AD) besteht und integraler Bestandteil derselben ist.

11. Vorrichtung nach einem der Ansprüche 1 bis 8,
bei der das Stützelement (SE) mit der Abdeckung (AD) durch Aufkleben, Aufschmelzen oder Aufschweißen verbunden ist.

12. Vorrichtung nach einem der Ansprüche 1 bis 11,
bei der das lichtemittierende Element (LE) in Teilbereiche strukturiert ist, die sich unabhängig voneinander elektrisch ansteuern lassen.

13. Vorrichtung nach einem der Ansprüche 1 bis 12,
bei der die Abdeckung (AD) zum Substrat (SU) weisend eine Glasschicht aufweist, in die die Vertiefungen (V) geätzt sind, wobei das Stützelement (SE) als Erhebungen verbleibt.

14. Vorrichtung nach einem der Ansprüche 1 bis 13,
bei dem die Abdeckung (AD) im Dichtbereich (DB) auf der zum Substrat (SU) weisenden Oberfläche einen umlaufenden Wulst aufweist, der zumindest über den Vertiefungen (V) erhaben ist.

15. Vorrichtung nach Anspruch 14, bei der der Wulst über das Stützelement (SE) erhaben ist.

## Claims

1. Light-emitting device,
- with a substrate (SU)
- with a light-emitting element (LE) arranged flat thereon
- with a cover (AD),
- in which the light-emitting element is enclosed in a sealed manner between the substrate and the cover,
- in which at least one depression (V) that is open towards the light-emitting element and together with it encloses a cavity is provided in the cover,
- in which a getter material (GE) is arranged on the cover, enclosed in the cavity,
- in which the cover has a supporting element (SE), with which it is supported on the light-emitting element in a central supporting region (AB) at a distance from the edge,
- in which the supporting element (SE) rests centrally on a supporting region (AB) and has a bearing surface that takes up the entire supporting region,
wherein in the supporting region an organic, inorganic or mixed buffer layer (PS) is arranged between the supporting element and the light-emitting element,
**characterized in that** the supporting element and the buffer layer completely cover the light-emitting element.

2. Device according to Claim 1,
in which the light-emitting element (LE) is an OLED.

3. Device according to Claim 1 or 2,
in which a sealing region (DB), which is free of the light-emitting element (LE), is provided between the cover (AD) and the substrate (SU) in the region of the outer edge of the cover,
in which, at least in the sealing region, a sealing compound (DM), which seals the outer join between the cover and the substrate, is arranged peripherally.

4. Device according to Claim 3,
in which the cavity directly adjoins the sealing region (DB).

5. Device according to Claim 3 or 4,
in which the sealing compound (DM) and the buffer layer (PS) consist of the same material.

6. Device according to one of Claims 1 to 4,
in which the substrate (SU) and the cover (AD) each comprise a layer of glass.

7. Device according to one of Claims 1 to 6,
in which the getter material (GE) is an oxidisable material that can react with oxygen and moisture and thereby bind them.

8. Device according to one of Claims 1 to 7,
in which the substrate (SU) is at least partially transmissive to the light radiated by the light-emitting element (LE).

9. Device according to one of Claims 1 to 8,
in which the cover (AD) comprises a layer of glass in which the at least one depression (V) is impressed.

10. Device according to one of Claims 1 to 8,
in which the supporting element (SE) consists of the material of the cover (AD) and is an integral part of the same.

11. Device according to one of Claims 1 to 8,
in which the supporting element (SE) is connected to the cover (AD) by being adhesively bonded, fused or welded on.

12. Device according to one of Claims 1 to 11,
in which the light-emitting element (LE) is structured in subregions that can be electrically activated independently of one another.

13. Device according to one of Claims 1 to 12,
in which the cover (AD) has facing the substrate (SU) a layer of glass in which the depressions (V) are etched, wherein the supporting element (SE) remains as elevations.

14. Device according to one of Claims 1 to 13,
in which the cover (AD) has in the sealing region (DB), on the surface facing the substrate (SU), a peripheral bead that is raised at least above the depressions (V).

15. Device according to Claim 14,
in which the bead is raised above the supporting element (SE).

## Revendications

1. Dispositif émettant de la lumière,
- avec un substrat (SU) ;
- avec un élément émettant de la lumière (LE) et disposé sur la surface du substrat ;
- avec un cache (AD) ;
- pour lequel l'élément émettant de la lumière est enfermé de façon étanche entre le substrat et le cache ;
- pour lequel tout au moins un renfoncement (V) est prévu dans le cache, lequel renfoncement est ouvert en direction de l'élément émettant de la lumière et comprend avec celui-ci une cavité ;
- pour lequel une matière de sorption (GE) est disposée sur le cache, dans la cavité ;
- pour lequel le cache présente un élément de support (SE), au moyen duquel il prend appui sur l'élément émettant de la lumière, dans une zone de soutien (AB) centrale éloignée du bord ;
- pour lequel l'élément de support (SE) repose de manière centralisée sur une zone de soutien (AB) et présente une surface d'appui qui occupe la totalité de la zone de soutien ; dans lequel une couche formant tampon (PS) organique, anorganique ou mixte est disposée dans la zone de soutien entre l'élément de support et l'élément émettant de la lumière, **caractérisé en ce que** l'élément de support et la couche formant tampon recouvrent intégralement l'élément émettant de la lumière.

2. Dispositif selon la revendication 1,
pour lequel l'élément émettant de la lumière (LE) est une diode électroluminescente organique (DELo).

3. Dispositif selon la revendication 1 ou 2,
pour lequel une zone d'étanchéité (DB) est prévue entre le cache (AD) et le substrat (SU), dans la zone de la bordure extérieure du cache, laquelle zone d'étanchéité est dépourvue de l'élément émettant de la lumière (LE) ; pour lequel tout au moins une masse de scellement (DM) est disposée sur tout le pourtour de la zone d'étanchéité, laquelle masse de scellement assure l'étanchéité du joint externe qui se trouve entre le cache et le substrat.

4. Dispositif selon la revendication 3,
pour lequel la cavité vient se raccorder directement à la zone d'étanchéité (DB).

5. Dispositif selon la revendication 3 ou 4,
pour lequel la masse de scellement (DM) et la couche formant tampon (PS) sont composées du même matériau.

6. Dispositif selon l'une des revendications 1 à 4,
pour lequel le substrat (SU) et le cache (AD) comprennent chacun une couche de verre.

7. Dispositif selon l'une des revendications 1 à 6,
pour lequel la matière de sorption (GE) est un matériau oxydable qui réagit à l'oxygène et à l'humidité et peut, à cet effet, les lier.

8. Dispositif selon l'une des revendications 1 à 7,
pour lequel le substrat (SU) est perméable, tout au moins en partie, pour la lumière émise par l'élément émettant de la lumière (LE).

9. Dispositif selon l'une des revendications 1 à 8,
pour lequel le cache (AD) comprend une couche de verre, dans laquelle le tout au moins un renfoncement (V) est imprimé.

10. Dispositif selon l'une des revendications 1 à 8,
pour lequel l'élément de support (SE) est constitué par le matériau du cache (AD) et forme une partie intégrante de celui-ci.

11. Dispositif selon l'une des revendications 1 à 8,
pour lequel l'élément de support (SE) est relié au cache (AD) par un procédé d'encollage, de fusion ou de soudage.

12. Dispositif selon l'une des revendications 1 à 11,
pour lequel l'élément émettant de la lumière (LE) est structuré en zones partielles qui peuvent être commandées électriquement de manière indépendante les unes des autres.

13. Dispositif selon l'une des revendications 1 à 12,
pour lequel le cache (AD) présente une couche de verre orientée en direction du substrat (SU), dans laquelle sont gravés les renfoncements (V) ; dans lequel l'élément de support (SE) demeure sous la forme de saillies.

14. Dispositif selon l'une des revendications 1 à 13,
pour lequel le cache (AD) présente un renflement circulaire dans la zone d'étanchéité (DB), sur la surface qui est orientée en direction du substrat (SU), lequel renflement est en relief tout au moins au dessus des renfoncements (V).

15. Dispositif selon la revendication 14,
pour lequel le renflement est en relief à travers l'élément de support (SE).
